**Europäisches Patentamt**

**European Patent Office**

**Office européen des brevets**

(19)

(11) Numéro de publication: **0 194 216
B1**

(12)

# FASCICULE DE BREVET EUROPEEN

(45) Date de publication du fascicule du brevet:
**11.01.89**

(21) Numéro de dépôt: **86420059.7**

(22) Date de dépôt: **24.02.86**

(51) Int. Cl.⁴: **H01L 23/46**

(54) **Substrat monolithique pour composant électronique de puissance, et procédé pour sa fabrication.**

(30) Priorité: **26.02.85 FR 8502749**

(43) Date de publication de la demande:
**10.09.86 Bulletin 86/37**

(45) Mention de la délivrance du brevet:
**11.01.89 Bulletin 89/2**

(84) Etats contractants désignés:
**DE FR GB IT NL**

(56) Documents cités:
**DE-A- 3 133 485
DE-A- 3 329 325**

(73) Titulaire: **XERAM, Tour Manhattan 6, place de l'Iris La Défense 2, F-92400 COURBEVOIE(FR)**

(72) Inventeur: **Dubuisson, Jacques, 22, avenue Emile Zola, F-75015 Paris(FR)**
Inventeur: **Boutterin, René, 9, rue de l'Etang Linas, F-91310 Montlhery(FR)**

(74) Mandataire: **Pascaud, Claude et al, PECHINEY 28, rue de Bonnel, F-69433 Lyon Cédex 3(FR)**

## Description

La présente invention concerne les substrats monolithiques pour composants électroniques de puissance; ces substrats sont formés d'un empilement fritté de couches de matériau diélectrique, généralement une céramique, ou une alumine dans les applications hyperfréquences.

De tels substrats sont utilisables aussi bien pour supporter des puces semi-conductrices à forte densité (ils sont alors connus sous le nom de "chip carrier"), ou comme substrats destinés à la réalisation de circuits hybrides, selon une technologie classique en elle-même. Dans l'un ou l'autre cas, ces substrats sont souvent des substrats d'interconnexion, c'est-à-dire qu'ils comportent des liaisons conductrices intégrées (enterrées dans le substrat ou formées à sa surface) qui seront par la suite reliées aux bornes du composant. Ces interconnexions sont souvent réparties sur plusieurs couches, des interconnexions de couche à couche et avec la surface du substrat étant incorporées selon un schéma préétabli.

En raison de la forte densité de composants, ou lorsqu'on souhaite utiliser des composants de puissance (amplificateurs en technologie hybride, par exemple), il devient nécessaire d'absorber et de dissiper un nombre important de calories dégagées par les composants. A titre d'exemple, il est courant d'avoir à dissiper une puissance de l'ordre de 35 watts par un substrat de dimensions normalisées 152,4 × 86,36 mm.

A cet effet, on choisit généralement pour le substrat un matériau bon conducteur de la chaleur, tel que l'alumine qui présent, en outre, d'excellentes propriétés diélectriques et mécaniques. Ce choix est important surtout lorsque des courants intenses parcourent les interconnexions enterrées, pour drainer les calories depuis le coeur du substrat vers sa surface.

Pour dissiper les calories ainsi drainées, une première méthode consiste à utiliser des radiateurs métalliques collés au dos du substrat, la chaleur étant évacuée par conduction à travers la masse de ce radiateur, puis par convection naturelle ou forcée vers l'atmosphère ambiante.

Une autre technique, qui peut être utilisée en combinaison avec la précédente, consiste à prévoir au coeur du substrat des métallisations faisant office de drains thermiques et débouchant sur une face du substrat par des plots qui seront ensuite soudés à un châssis métallique, par exemple en cuivre ou en duralumin.

Ces deux techniques ont cependant l'inconvénient d'occuper une face entière du substrat qui n'est donc plus disponible pour le report de composants, de nécessiter des masses métalliques importantes pour évacuer les calories par conduction puis convection, et enfin de limiter, pour cette raison, les possibilités de dispositions physiques du substrat et des composants à l'intérieur de l'appareillage.

En tout état de cause, la possibilité d'absorber in situ les calories dégagées est limitée du fait de l'interposition d'un organe intermédiaire, drain thermique ou radiateur.

L'invention propose une nouvelle structure de substrat permettant de remédier à ces inconvénients.

Le substrat de l'invention comporte à cet effet un réseau interne de canaux pour la circulation d'un fluide de refroidissement, ce réseau étant un réseau fermé débouchant en surface du substrat par deux orifices permettant respectivement l'admission du fluide sous pression dans le réseau interne de canaux et son prélèvement hors de ce réseau.

De préférence, le réseau est formé de segments de canaux répartis sur plusieurs niveaux, ces segments étant interconnectés d'un niveau au suivant.

De préférence, l'interconnexion de canaux est réalisée par des puits formés par enlèvement de matière dans les couches à traverser.

En variante ou en complément, l'interconnexion des canaux peut également être réalisée par des régions en regard des segments de canaux appartenant à deux couches adjacentes.

Dans un premier mode de réalisation, les canaux sont définis entre deux couches adjacentes par un volume résiduel formé à l'interface de celles-ci le long d'un motif prédéterminé.

Dans un second mode de réalisation, les canaux sont définis par enlèvement de matière dans certaines couches de l'empilement selon un motif prédéterminé.

L'invention concerne également un procédé de fabrication du substrat selon le premier mode de réalisation précité, dans lequel le volume résiduel est obtenu par dépôt d'une encre évanescente selon le motif prédéterminé sur au moins l'une des feuilles de matériau diélectrique cru avant empilement, cette encre évanescente étant une encre dépourvue de pigment minéral, propre à empêcher au moment de la cuisson le co-frittage des deux couches adjacentes le long dudit motif.

D'autres caractéristiques et avantages de l'invention apparaîtront plus clairement à la lecture de la description détaillée qui va suivre, faite en référence aux dessins annexés, sur lesquels :

· la figure 1 est une vue en coupe d'un substrat selon le premier mode de réalisation précité,
· la figure 2 est homologue de la figure 1, pour le second mode de réalisation précité,
· les figures 3a à 3d montrent le dessin des ouvertures poinçonnées dans chacune des couches du substrat pour former le réseau de circulation de fluide du second mode de réalisation précité.

On notera, tout d'abord, que, dans les descriptions qui vont suivre, le réseau de canaux pour la circulation du fluide de refroidissement est intégré au substrat de façon indissociable, les niveaux d'interconnexions électriques et les niveaux d'interconnexions des canaux étant imbriqués. L'invention s'applique cependant également à des substrats dans lesquels le réseau des interconnexions électriques et le réseau des canaux sont deux réseaux étagés, non imbriqués : tel est en particulier le cas lorsque le substrat final est réalisé à partir de deux substrats superposés et solidarisés en un seul élément monolithique (par frittage, collage ...) l'un des substrats de départ étant un substrat d'interconnexion électrique classique, et l'autre substrat de départ étant un substrat spécifique de refroidissement accolé au précédent.

D'autre part, le matériau préférentiel utilisé pour ces substrats est l'alumine, en raison de ses excellentes propriétés thermiques (très bon conducteur), diélectriques (permettant un emploi en hyperfréquences) et mécaniques. Une composition préférentielle est celle décrite en détail dans la demande de brevet français n° 83-19689 du 8 décembre 1983, au nom de la Demanderesse, intitulée "Substrat d'interconnexion en alumine pour composant électronique": cette composition comprend 92 à 98% d'$Al_2O_3$ (de préférence 96%), le restant étant constitué de titanate de magnésie dont la formule est comprise entre ($TiO_2$, 0,5 MgO) et ($TiO_2$, 6 MgO), de préférence ($TiO_2$, MgO), les motifs conducteurs étant réalisés en palladium ou en un alliage argent-palladium.

Cette composition présente l'avantage de conserver toutes les propriétés de l'alumine ultra-pure, en abaissant toutefois la température maximale de cuisson à une valeur de l'ordre de 1400°, cuisson qui au surplus peut être réalisée en atmosphère oxydante.

Si cette composition est préférentielle, elle n'en est pas pour autant limitative, et d'autres matériaux peuvent être utilisés, tels que l'alumine ultra-pure ou les céramiques de types classiques employées pour ce type de substrat.

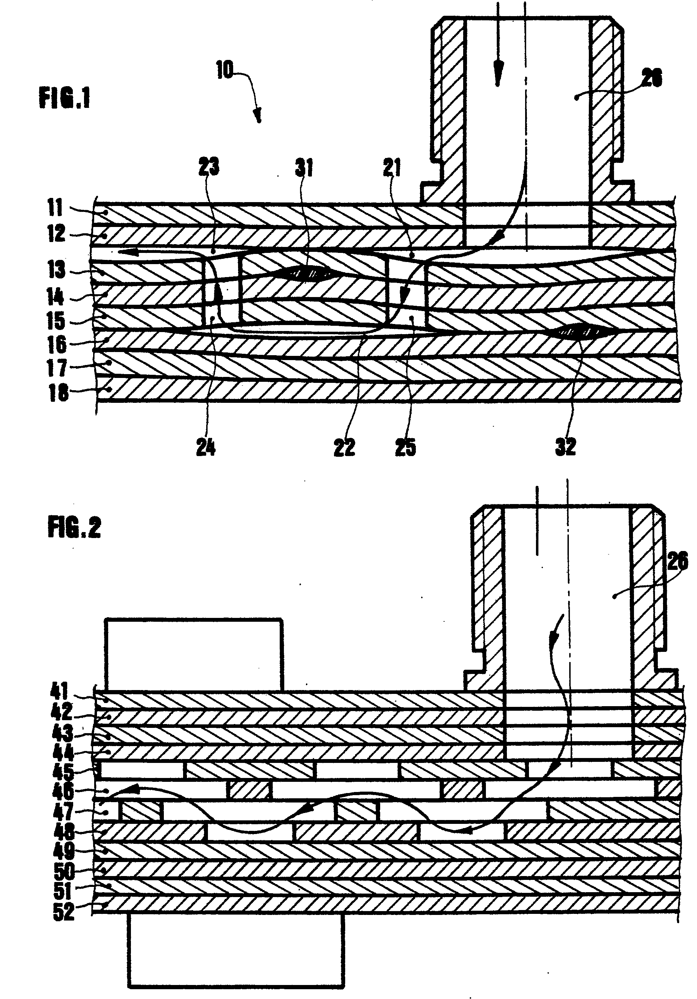

La figure 1 illustre un premier mode de réalisation, dans lequel le substrat 10 est formé d'un empilement fritté de couches 11, 12, ... 18 de matériau diélectrique. Le réseau interne de canaux est formé d'une série de segments de canaux 21, 22, 23 définis entre deux couches adjacentes (par exemple les couches 12 et 13, ou 15 et 16, respectivement) par un volume résiduel formé à l'interface de celles-ci le long d'un motif prédéterminé. Les interconnexions sont réalisées par des puits 24, 25 formés par enlèvement de matière dans les couches à traverser. Sur la figure a été représenté l'orifice d'admission de fluide sous pression 26 communiquant avec le réseau interne de canaux.

Cet orifice est relié à un circuit primaire de fluide, généralement un circuit fermé qui recycle le fluide prélevé hors du réseau interne du substrat par un autre orifice (non représenté) par l'intermédiaire d'un échangeur thermique et d'une pompe, selon un schéma classique en lui-même. Le fluide de refroidissement peut être l'eau, ou de préférence un fluide inerte approprié, tel que le FLUORINERT (marque déposée de la Société 3M) ou le GALDEN (marque déposée de la Société MONSANTO), qui sont des liquides fluorés couramment utilisés pour le refroidissement des châssis ou des radiateurs de circuits électroniques.

Le fluide utilisé peut être également un fluide gazeux; le choix est en fait conditionné par la quantité de calories dégagées et par la capacité de l'échangeur thermique à évacuer les calories prélevées in situ.

La pompe et l'échangeur thermique peuvent être communs à l'ensemble de l'appareillage et alimenter une pluralité de substrats conçus sur le même principe; cette centralisation, qui n'était pas possible avec les radiateurs de types classiques (nécessairement individuels), assure un gain de volume et de poids considérable pour les appareillages regroupant un nombre élevé de circuits répartis sur des substrats distincts.

Le réseau de circulation de fluide peut être optimisé en fonction du circuit qu'est destiné à supporter le substrat: une fois les points chauds localisés (par exemple par thermographie infrarouge), on cherche à réduire l'épaisseur d'alumine à traverser par les calories entre le point chaud et le canal le plus proche assurant l'échange thermique primaire, c'est-à-dire l'absorption des calories in situ. De la sorte, il est possible de concevoir des circuits de forte puissance pouvant fonctionner à des températures ambiantes élevées: une température maximale de fonctionnement de 80–85°C et une température maximale de jonction de 110–120°C limitent en effet l'écart maximal de température à 30° environ. De telles performances peuvent être atteintes, dans la gamme de puissances et le format indiqués plus haut, grâce à la structure de l'invention.

Pour réaliser le substrat de la figure 1, le procédé comprend les étapes suivantes:

·Dépôt sur un certain nombre de couches d'une pâte évanescente (c'est-à-dire une pâte qui disparaîtra totalement lors de la cuisson, donc une encre sans pigment minéral), selon un motif correspondant aux différents segments de canaux à former au niveau correspondant.

La substance évanescente peut être un liant classique, tel qu'un polyvinylbutyral non chargé, dès lors qu'il est adapté au liant de la céramique, c'est-à-dire qu'il ne réagit pas avec celui-ci.

·De la même façon, dépôt d'une encre chargée d'un pigment minéral pour former la réseau d'interconnexions électriques (ces interconnexions sont désignées 31 et 32, par exemple, sur la figure 1).

·Perçage des trous d'interconnexions de couche à couche et d'un couche à la surface : il peut s'agir soit d'interconnecter les segments de canaux du réseau de refroidissement (les trous ne sont alors pas métallisés), soit d'interconnecter les pistes conductrices (les trous sont alors métallisés, de façon classique).

·Empilement des différentes couche

·Empilement et compression des différentes couches.

·Cuisson et frittage du bloc ainsi obtenu: la surépaisseur formée à l'endroit où la pâte évanescente a été déposée va empêcher le frittage des deux couches adjacentes; lors de la cuisson, cette pâte va peu à peu disparaître, laissant subsister un volume résiduel à l'interface des deux couches; ce sont ces volumes résiduels qui constitueront ensemble les segments de canaux du réseau de refroidissement.

Il est possible de réaliser par cette méthode des canaux ayant une épaisseur maximale de 20 μm (typiquement 12–15 μm) et ayant une largeur de l'ordre de 1 à 1,5 mm. L'épaisseur totale du substrat est de l'ordre de 1 à 1,5 mm, et l'utilisation du type particulier d'alumine cité plus haut permet de faire circuler directement le fluide a cru sur l'alumine, celle-ci n'ayant pratiquement pas de porosité (porosité toujours inférieure à 1 μm).

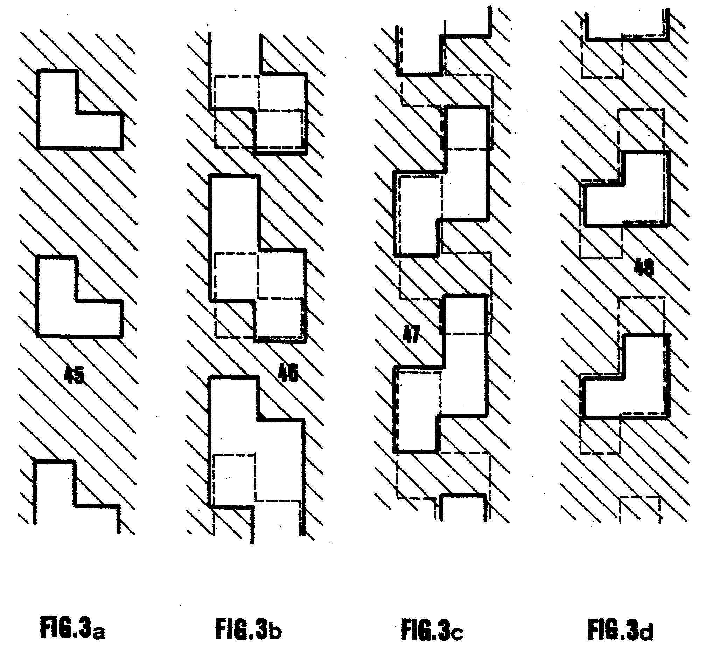

La figure 2 illustre un second mode de réalisation, dans lequel les segments de canaux ne sont plus définis à l'interface de deux couches adjacentes, mais par enlèvement de matière dans certaines couches de l'empilement, selon un motif prédéterminé: sur la figure 2, on a par exemple perforé les couches désignées 45 à 48 de la manière illustrée figures 3a à 3d, respectivement; sur les figures 3b à 3d, on a illustrée en tireté le motif de la couche immédiatement inférieure, de manière à faire apparaître plus clairement les régions par lesquelles le fluide peut passer d'un niveau de couche au suivant.

Si l'on considère la figure 3c, on peut observer que deux niveaux de couches pourvus de motifs appropriés sont suffisants pour assurer la circulation du fluide; on préfère cependant ajouter les motifs des couches 45 et 48 pour faciliter la circulation du fluide aux endroits où pourrait se créer une perte de charge.

L'épaisseur de chacune des couches ainsi perforées peut varier entre 50 et 250 μm. Si l'on prévoit qu'il existe toujours une surface commune à au moins deux couches, l'épaisseur de passage peut ainsi être de 0,1 à 0,5 mm, pour une largeur de l'ordre de 1 mm à 2 mm.

## Revendications

1. Un subtrat monolithique pour composant électronique de puissance, formé d'un empilement fritté de couches (11, 12, 13, 14, 15, 16, 17, 18) de matériau diélectrique, caractérisé en ce qu'il comporte un réseau interne de canaux pour la circulation d'un fluide de refroidissement, ce réseau étant un réseau fermé débouchant en surface du substrat par deux orifices permettant respectivement l'admission du fluide sous pression dans le réseau interne de canaux et son prélèvement hors de ce réseau.

2. Un substrat monolithique selon la revendication 1, caractérisé en ce que le réseau est formé de segments (21, 22, 23) de canaux répartis sur plusieurs niveaux, ces segments étant interconnectés d'un niveau au suivant.

3. Un substrat monolithique selon la revendication 2, caractérisé en ce que l'interconnexion des canaux est réalisée par des puits (24, 25) formés par enlèvement de matière dans les couches à traverser.

4. Un substrat monolithique selon la revendication 2, caractérisé en ce que l'interconnexion des canaux est réalisée par les régions en regard des segments de canaux appartenant à deux couches adjacentes.

5. Un substrat monolithique selon la revendication 1, caractérisé en ce que les canaux sont définis entre deux couches adjacentes par un volume résisuel formé à l'interface de celles-ci le long d'un motif prédéterminé.

6. Un substrat monolithique selon la revendication 1, caractérisé en ce que les canaux sont définis par enlèvement de matière dans certaines couches de l'empilement selon un motif prédéterminé.

7. Procédé de réalisation d'un substrat selon la revendication 5, caractérisé en ce que le volume résiduel est obtenu par dépôt d'une encre évanescente selon le motif prédéterminé sur au moins l'une des feuilles de matériau diélectrique cru avant empilement, cette encre évanescente étant une encre dépourvue de pigment minéral, propre à empêcher au moment de la cuisson le co-frittage des deux couches adjacentes le long dudit motif.

## Patentansprüche

1. Monolithisches Substrat für elektronisches Leistungsbauelement, gebildet aus einem gefritteten oder gesinterten Stapel von dielektrischen Materialschichten (11, 12, 13, 14, 15, 16, 17, 18), dadurch gekennzeichnet, daß es ein inneres Netz von Kanälen für die Zirkulation eines Kühlfluides aufweist, wobei das Netz ein geschlossenes Netz ist, das an der Oberfläche des Substrats durch zwei Öffnungen gebildet ist, die die Zufuhr des Fluids unter Druck in das innere Netz der Kanäle beziehungsweise seine Entnahme aus dem Netz erlauben.

2. Monolithisches Substrat nach Anspruch 1, dadurch gekennzeichnet, daß das Netz aus Kanalsegmenten (21, 22, 23,) gebildet ist, die über mehrere Niveaus verteilt sind, wobei die Segmente von einem Niveau zum nächsten miteinander verbunden sind.

3. Monolithisches Substrat nach Anspruch 2, dadurch gekennzeichnet, daß die Zwischenverbindung der Kanäle durch Schächte (24, 25) verwirklicht ist, die durch Herausnahme von Material in den zu durchdringenden Schichten gebildet sind.

4. Monolithisches Substrat nach Anspruch 2, dadurch gekennzeichnet, daß die Zwischenverbindung der Kanäle durch die den Kanalsegmenten gegenüberliegenden Gebiete gebildet ist, die auf zwei benachbarten Schichten erscheinen.

5. Monolithisches Substrat nach Anspruch 1, dadurch gekennzeichnet, daß die Kanäle zwischen zwei benachbarten Schichten durch ein Restvolumen definiert sind, das an ihrer Verbindungsfläche entlang eines vorbestimmten Musters gebildet ist.

6. Monolithisches Substrat nach Anspruch 1, dadurch gekennzeichnet, daß die Kanäle durch Wegnahme von Material in bestimmten Schichten des Stapels nach einem vorbestimmten Muster gebildet sind.

7. Verfahren zur Herstellung eines Substrates nach Anspruch 5, dadurch gekennzeichnet, daß das Restvolumen durch Einlagerung einer verschwindenden Tinte gemäß dem vorbestimmten Muster wenigstens auf einer der unbehandelten dielektrischen Materialfolien vor dem Stapeln erhalten wird, wobei die verschwindende Tinte nicht aus Mineralpigmenten gebildet ist, und geeignet ist, ein Zusammenschmelzen der beiden benachbarten Schichten entlang des Musters während des Schmelzens zu verhindern.

## Claims

1. A monolithic substrate for an electronic power component which is formed by a sintered stack of layers (11, 12, 13, 14, 15, 16, 17, 18) of dielectric material characterised in that it comprises an internal system of ducts for the circulation of a cooling fluid, said system being a closed system which opens at the surface of the substrate by way of two orifices which respectively provide for the intake of the pressurized fluid into the internal system of ducts and the removal thereof from said system.

2. A monolithic substrate according to claim 1 characterised in that the system is formed by segments (21, 22, 23) of ducts which are distributed over a plurality of levels, said segments being interconnected from one level to the next.

3. A monolithic substrate according to claim 2 characterised in that the ducts are interconnected by means of wells (24, 25) formed by the removal of material in layers through which the fluid is to pass.

4. A monolithic substrate according to claim 2 characterised in that the ducts are interconnected by mutually facing regions of the segments of ducts which belong to two adjacent layers.

5. A monolithic substrate according to claim 1 characterised in that the ducts are defined between two adjacent layers by a residual volume formed at the interface of said layers along a predetermined pattern.

6. A monolithic substrate according to claim 1 characterised in that the ducts are defined by removing material in certain layers of the stack, in accordance with a predetermined pattern.

7. A process for the production of a substrate according to claim 5 characterised in that the residual volume is produced by the deposit of an evanescent ink in accordance with the predetermined pattern on at least one of the sheets of raw dielectric material before stacking, said ink being an ink which is devoid of mineral pigment and which is suitable to prevent at the moment of baking co-sintering of the two adjacent layers along said pattern.

FIG.1

FIG.2

FIG.3a    FIG.3b    FIG.3c    FIG.3d